(19) Europäisches Patentamt
European Patent Office
Office européen des brevets

(11) **EP 2 455 769 A1**

(12) **EUROPEAN PATENT APPLICATION**
published in accordance with Art. 153(4) EPC

(43) Date of publication:
**23.05.2012 Bulletin 2012/21**

(51) Int Cl.:
***G01R 31/00*** *(2006.01)* ***G01R 31/02*** *(2006.01)*
***H01G 13/00*** *(2006.01)*

(21) Application number: **09847322.6**

(22) Date of filing: **14.07.2009**

(86) International application number:
**PCT/JP2009/062758**

(87) International publication number:
**WO 2011/007424 (20.01.2011 Gazette 2011/03)**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(71) Applicant: **Mitsubishi Electric Corporation Tokyo 100-8310 (JP)**

(72) Inventors:
• **HAYASHI, Kentaro Tokyo 100-8310 (JP)**
• **OSADA, Kazuya Tokyo 100-8310 (JP)**
• **NAKABAYASHI, Hirokazu Tokyo 100-8310 (JP)**

(74) Representative: **Pfenning, Meinig & Partner GbR Patent- und Rechtsanwälte Theresienhöhe 13 80339 München (DE)**

(54) **CAPACITOR ABNORMALITY DETECTOR**

(57) A capacitor abnormality detecting apparatus that enables a further reduction in circuit main components is provided. DC buses 7N and 8N on a negative side are connected in common to DC power supply circuits 10a and 10b. A voltage detecting circuit 15a detects a voltage between DC buses 7P and 7N of the DC power supply circuit 10a. A voltage detecting circuit 15b detects a voltage between DC buses 8P and 8N of the DC power supply circuit 10b. The voltage detecting circuit 15c detects a differential voltage between a terminal voltage of a capacitor 4c and a terminal voltage of a capacitor 5c. An adding and subtracting circuit 17 calculates a differential voltage between an output voltage of the voltage detecting circuit 15a multiplied with 1/3 by a constant multiplication circuit 16a and an output voltage of the voltage detecting circuit 15b multiplied with 1/3 by a constant multiplication circuit 16b. A comparing and determining circuit 18 determines abnormality of capacitors 4a to 4c or capacitors 5a to 5c based on an output voltage of the adding and subtracting circuit 17 and an output voltage of the voltage detecting circuit 15c.

FIG.1

EP 2 455 769 A1

**Description**

Field

The present invention relates to a capacitor abnormality detecting apparatus that detects abnormality of a capacitor group including a plurality of capacitors connected in series between DC buses.

Background

As an apparatus (a circuit) that detects abnormality of a plurality of capacitors connected in series between DC buses, for example, there is an apparatus disclosed in Patent Literature 1. In the abnormality detecting apparatus disclosed in Patent Literature 1, a configuration is disclosed in which an arithmetic amplifier that creates reference signals at a predetermined upper limit level and a predetermined lower limit level between which a voltage value for one capacitor is set at normal time is provided and a comparator detects that an applied voltage for one capacitor deviates from an upper limit and lower limit range that the applied voltage should take at normal time.

Citation List

Patent Literature

Patent Literature 1: Japanese Patent Application Laid-open No. H4-120475

Summary

Technical Problem

However, in the abnormality detecting apparatus disclosed in Patent Literature 1, the configuration of a detection circuit for one DC power input is only disclosed. A plurality of DC power supply inputs are not taken into account. Therefore, a circuit configuration obtained when the technology disclosed in Patent Literature 1 is applied to a plurality of DC power supply inputs is redundant. A further reduction in circuit main components is possible.
The present invention has been devised in view of the above and it is an object of the present invention to provide a capacitor abnormality detecting apparatus that detects abnormality of a capacitor group including a plurality of capacitors connected in series between DC buses, the capacitor abnormality detecting apparatus enabling a further reduction in circuit main components.

Solution to Problem

In order to solve the aforementioned problems and attain the aforementioned object, according to an aspect of the present invention, the capacitor abnormality detecting apparatus that detects abnormality of a capacitor group including a plurality of capacitors connected in series between DC buses of a DC power supply, the DC power supply including first and second DC power supplies to which DC buses on a negative side are connected in common, the capacitor abnormality detecting apparatus is provided with: a first voltage detecting circuit that detects a voltage between first DC buses in the first DC power supply; a second voltage detecting circuit that detects a voltage between second DC buses in the second DC power supply; a third voltage detecting circuit that detects a differential voltage between a terminal voltage of any one capacitor belonging to a first capacitor group connected between the first DC buses and a terminal voltage of any one capacitor belonging to a second capacitor group connected between the second DC buses; and a comparing and determining circuit that determines abnormality of capacitors belonging to the first capacitor group or the second capacitor group based on output voltages of the first to third voltage detecting circuits.

Advantageous Effects of Invention

According to the present invention, there is an effect that it is possible to provide a capacitor abnormality detecting apparatus that enables a further reduction in circuit main components.

Brief Description of Drawings

FIG. 1 is a circuit diagram of the configuration of a capacitor abnormality detecting apparatus according to a first embodiment of the present invention.

FIG. 2 is a circuit diagram of the configuration of a capacitor abnormality detecting apparatus according to a second embodiment of the present invention.

FIG. 3 is a circuit diagram of the configuration of a capacitor abnormality detecting apparatus according to a third embodiment of the present invention.

FIG. 4 is a table in which required numbers of voltage detecting circuits and comparing and determining circuits are shown in comparison with each other.

Description of Embodiments

Capacitor abnormality detecting apparatuses according to embodiments of the present invention are explained in detail below with reference to the accompanying drawings. The present invention is not limited by contents explained below.

First Embodiment.

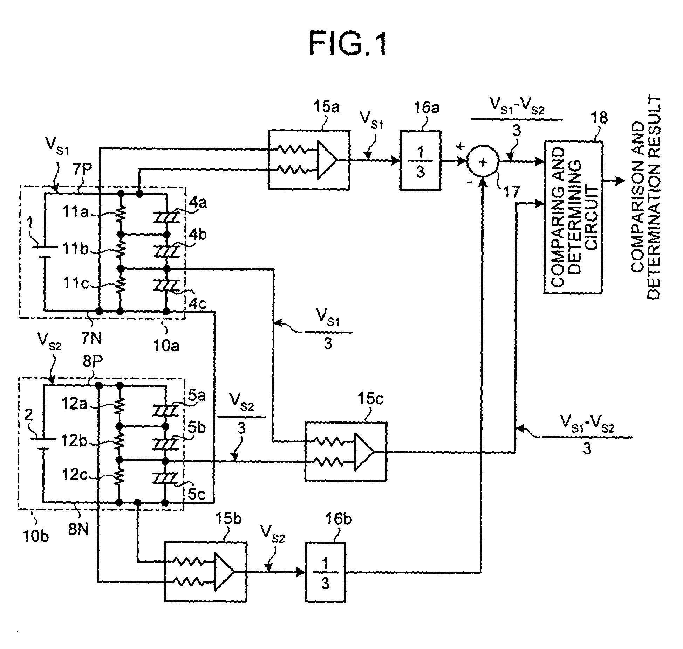

FIG. 1 is a circuit diagram of the configuration of a capacitor abnormality detecting apparatus according to a first embodiment of the present invention. As shown in FIG. 1, the capacitor abnormality detecting apparatus according to the first embodiment is shown as an apparatus that includes a plurality of DC power supplies (in FIG. 1, two DC power supplies are shown as an example), which are solar cell battery modules, fuel cells, or the like, as DC inputs and detects abnormality of a capacitor group including a plurality of capacitors connected in series between DC buses of these DC power supplies. A specific configuration of the capacitor abnormality detecting apparatus is as explained below.

In FIG. 1, a DC power supply 1, which is a first DC power supply, and a DC power supply 2, which is a second power supply, are connected in common such that a DC bus 7N on a negative side drawn out from a negative pole of the DC power supply 1 and a DC bus 8N on the negative side drawn out from a negative pole of the DC power supply 2 have the same potential. Capacitors 4a to 4c, which are a first capacitor group connected in series, are connected between a DC bus 7P on a positive side drawn out from a positive pole of the DC power supply 1 and the DC bus 7N on the negative side, i.e., between first DC buses including the DC buses 7P and 7N. A voltage between the DC buses 7P and 7N is divided by resistors 11a to 11c. Capacitors 5a to 5c, which are a second capacitor group connected in series, are connected between a DC bus 8P on the positive side drawn out from a positive pole of the DC power supply 2 and the DC bus 8N on the negative side, i.e., second DC buses including the DC buses 8P and 8N. A voltage between the DC buses 8P and 8N is divided by resistors 12a to 12c. A DC power supply circuit 10a includes the DC power supply 1 and the capacitors 4a to 4c. A DC power supply circuit 10b includes the DC power supply 2 and the capacitors 5a to 5c.

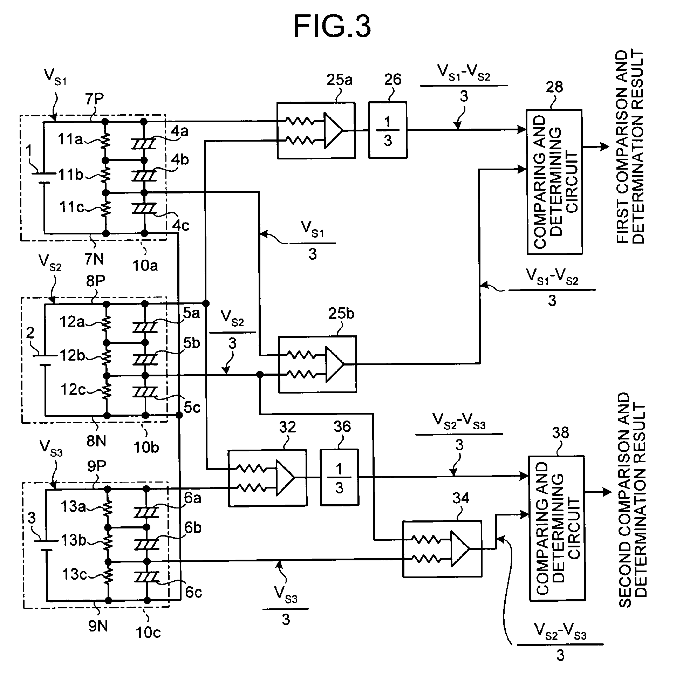

The capacitor abnormality detecting apparatus according to the first embodiment includes a voltage detecting circuit 15a as a first voltage detecting circuit that detects an inter-DC bus voltage (a voltage between the DC buses 7P and 7N) in the DC power supply circuit 10a, a voltage detecting circuit 15b as a second voltage detecting circuit that detects an inter-DC bus voltage (a voltage between the DC buses 8P and 8N) in the DC power supply circuit 10b, a voltage detecting circuit 15c as a third voltage detecting circuit that detects a voltage (a potential difference) between a terminal voltage of one capacitor (in FIG. 1, the capacitor 4c is shown as an example) arbitrarily selected out of the capacitors 4a to 4c and a terminal voltage of one capacitor (in FIG. 1, the capacitor 5c is shown as an example) arbitrarily selected out of the capacitors 5a to 5c, constant multiplication circuits 16a and 16b that respectively multiply output voltages of the voltage detecting circuits 15a and 15b with a constant (in FIG. 1, 1/3 is shown as an example), an adding and subtracting circuit 17 that calculates a differential voltage between the constant multiplication circuit 16a and the constant multiplication circuit 16b, and a comparing and determining circuit 18 that outputs a predetermined comparison and determination result based on a differential voltage between an output voltage of the adding and subtracting circuit 17 and an output voltage of the voltage detecting circuit 15c.

In FIG. 1, "$V_{S1}$" represents an output voltage of the DC power supply 1 and "$V_{S2}$" represents an output voltage of the DC power supply 2. In FIG. 1, it is assumed that a voltage between the DC buses 7P and 7N is divided by the resistors 11a to 11c having the same resistance. In this case, because terminal voltages of the capacitors are equal to one another, a value of the constant in the constant multiplication circuits 16a and 16b is set to "1/3". Therefore, when the resistances of the resistors 11a to 11c are not equal, the constant only has to be set to a value corresponding to the resistances (specifically, proportional to the resistances).

In FIG. 1, voltages of the capacitors 4c and 5c are respectively used as inputs to the voltage detecting circuit 15c. However, the inputs to the voltage detecting circuit 15c are not limited to this configuration. For example, in the circuit configuration shown in FIG. 1, voltages of the capacitors 4b and 5b (positive pole side voltages of the capacitors 4b and 5b (a terminal voltage between the capacitors 4a and 4b and a terminal voltage between the capacitors 5a and 5b)) can be the inputs to the voltage detecting circuit 15c.

The operation of the capacitor abnormality detecting apparatus according to the first embodiment is explained with reference to FIG. 1. In FIG. 1, "$V_{S1}$" represents a voltage of the DC bus 7P (the output voltage of the DC power supply 1) with reference to the DC bus 7N (the DC bus 8N). "$V_{S2}$" represents a voltage of the DC bus 8P (the output voltage of the DC power supply 2) with reference to the DC bus 7N (the DC bus 8N). In the following explanation, all voltages of respective sections are explained as voltages with reference to the DC bus 7N (the DC bus 8N).

<Operation performed when there is no abnormality in the capacitor groups>

First, when the capacitors 4a to 4c normally operate, terminal voltages of the capacitors 4a to 4c are balanced. Therefore, one input voltage to the voltage detecting circuit 15c is "$V_{S1}/3$". Similarly, when the capacitors 5a to 5c normally operate, the other input voltage to the voltage detecting circuit 15c is "$V_{S2}/3$". Therefore, the output voltage of the voltage detecting circuit 15c is "$(V_{S1}-V_{S2})/3$", which is a differential voltage between both the input voltages.
On the other hand, because a voltage between the DC buses 7P and 7N and a voltage between the DC buses 8P and 8N are respectively input to the voltage detecting circuits 15a and 15b, output voltages of the voltage detecting circuits 15a and 15b are respectively "$V_{S1}$" and "$V_{s2}$". Therefore, an output of the adding and subtracting circuit 17, which calculates a differential voltage between the output voltages via the constant multiplication circuits 16a and 16b, is "$(V_{S1}-V_{S2})/3$".
Therefore, even if slight fluctuation occurs in a terminal voltage of the capacitor 4c or the capacitor 5c because of, for example, output voltage fluctuation in the DC power supply 1 or the DC power supply 2, there is no significant difference between the output voltage of the adding and subtracting circuit 17 and the output voltage of the voltage detecting circuit 15c, which are input voltages to the comparing and determining circuit 18. A comparison and determination result, which is an output of the comparing and determining circuit 18, is "normal".

<Operation performed when there is abnormality in one of the capacitor groups>

As an example of an operation performed when there is abnormality in one of the capacitor groups, for example, when the capacitor 4a is short-circuited and fails (all the other capacitors are normal), the output voltage $V_{S1}$ of the DC power supply 1 is divided and applied to both ends of the capacitor 4b and the capacitor 4c. Therefore, an output voltage of the capacitor 4c rises to "$V_{S1}/2$".
Therefore, an output voltage of the voltage detecting circuit 15c is "$(V_{S1}/2)-(V_{S2}/3)$". A potential difference indicated by the following formula occurs between the output voltage "$(V_{S1}-V_{S2})/3$" of the adding and subtracting circuit 17 and the output voltage "$(V_{S1}/2)-(V_{s2}/3)$" of the voltage detecting circuit 15c, which are input voltages to the comparing and determining circuit 18.
$$\{(V_{S1}-V_{S2})/3\}-\{(V_{S1}/2)-(V_{S2}/3)\}=(V_{S1}/3-V_{S1}/2)-V_{S2}/3+V_{S2}/3=-V_{S1}/6$$

$$(1)$$

On the other hand, when the capacitor 5a is short-circuited and fails (all the other capacitors are normal), similarly, an output voltage of the capacitor 5c rises to "$V_{S1}/2$". A potential difference indicated by the following formula occurs between the output voltage "$(V_{S1}-V_{S2})/3$" of the adding and subtracting circuit 17 and an output voltage "$(V_{S1}/3)-(V_{S2}/2)$" of the voltage detecting circuit 15c, which are input voltages to the comparing and determining circuit 18.
$$\{(V_{S1}-V_{S2})/3\}-\{(V_{S1}/3)-(V_{S2}/2)\}=(V_{S1}/3-V_{S1}/3)-V_{S2}/3+V_{S2}/2=V_{S2}/6$$

$$(2)$$

When the capacitor 4a is short-circuited and fails, a result (1) of the comparing and determining circuit is a negative value. On the other hand, when the capacitor 5a is short-circuited and fails, a result (2) of the comparing and determining circuit is a positive value. It is possible to determine, according to a positive or negative value of the comparing and determining circuit, whether a capacitor connected to the DC power supply circuit 10a is short-circuited and fails or a capacitor connected to the DC circuit 10b is short-circuited and fails.
In the above explanation, the capacitor 4a of the DC power supply circuit 10a or the capacitor 5a of the DC circuit 10b is short-circuited and fails. The same potential difference can be detected when the capacitor 4b or 4c or the capacitor 5b or 5c, which is another capacitor, is short-circuited and fails. It is possible to detect "capacitor abnormality of the DC power supply circuit 10a" or "capacitor abnormality of the DC power supply circuit 10b".

In FIG. 1, the configuration for inputting the terminal voltage of the capacitor 4c to one input end of the voltage detecting circuit 15c and inputting the terminal voltage of the capacitor 5c to the other input terminal is shown as an example. However, a configuration for inputting terminal voltages is not limited to this configuration. For example, a configuration for inputting the terminal voltage of the capacitor 4b to one input terminal of the voltage detecting circuit 15c and inputting the terminal voltage of the capacitor 5c to the other input terminal can be adopted. In the case of such a configuration, a coefficient (a constant multiplication value) of the constant multiplication circuit 16a only has to be set to "2/3".

Concerning positive and negative of a result of the comparing and determining circuit 18, depending on a configuration, a result of the comparing and determining circuit 18 could be positive when "capacitor abnormality of the DC power supply circuit 10a" occurs. However, when "capacitor abnormality of the DC power supply circuit 10b" occurs, a result of the comparing and determining circuit 18 is negative. With respect to "capacitor abnormality of the DC power supply circuit 10a" and "capacitor abnormality of the DC power supply circuit 10b", if a result of the comparing and determining circuit 18 is positive on one side, the result is negative on the other side. Therefore, it is possible to determine a capacitor of which of the DC power supply circuit 10a and the DC power supply circuit 10b is abnormal.

In the case of the configuration shown in FIG. 1, when a capacitor in the DC power supply circuit 10a and a capacitor in the DC power supply circuit 10b simultaneously fail, it is likely that there is no significant difference in the input voltage to the comparing and determining circuit 18. However, such a concern is groundless because it is unlikely that a capacitor in the DC power supply circuit 10a and a capacitor in the DC power supply circuit 10b simultaneously fail. Further, it is extremely unlikely that that a capacitor in the DC power supply circuit 10a and a capacitor in the DC power supply circuit 10b simultaneously fail in the same detection period. Therefore, if a frequency of a detecting operation by the comparing and determining circuit 18 is increased or detection processing by the comparing and determining circuit 18 is cyclically or periodically performed, it is possible to surely detect "capacitor abnormality in the DC power supply circuit 10a or the DC power supply circuit 10b".

As explained above, with the capacitor abnormality detecting apparatus according to the first embodiment, when two DC power supplies to which DC buses on a negative side are connected in common are configured, the first voltage detecting circuit detects a voltage between first DC buses in a first DC power supply, the second voltage detecting circuit detects a voltage between second DC buses in a second DC power supply, the third voltage detecting circuit detects a differential voltage between a terminal voltage of any one capacitor belonging to a first capacitor group connected between the first DC buses, and a terminal voltage of any one capacitor belonging to a second capacitor group connected between the second DC buses, and the comparing and determining circuit determines abnormality of a capacitor belonging to the first capacitor group or the second capacitor group based on output voltages of the first to third voltage detecting circuits. Therefore, it is possible to reduce circuit main components necessary for the capacitor abnormality detecting apparatus.


Second Embodiment.


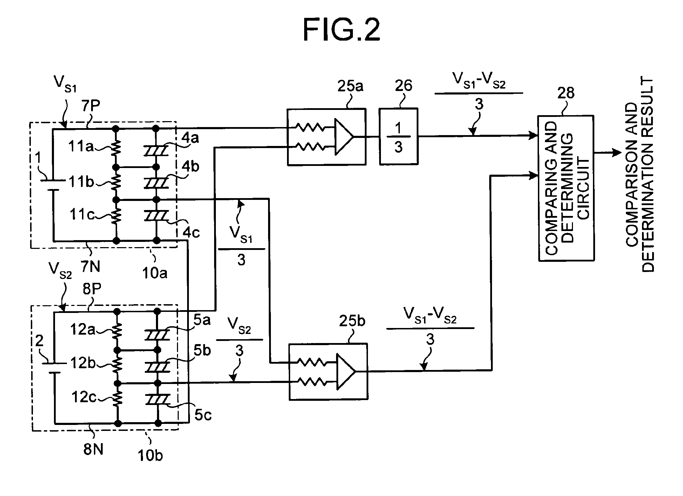

In the capacitor abnormality detecting apparatus according to the first embodiment, as the configuration for detecting abnormality of the capacitor groups respectively connected to the two DC power supplies, the configuration realized by the three voltage detecting circuits and the one comparing and determining circuit is disclosed. In a capacitor abnormality detecting apparatus according to a second embodiment, a configuration realized by two voltage detecting circuits and one comparing and determining circuit is disclosed. FIG. 2 is a circuit diagram of the configuration of the capacitor abnormality detecting apparatus according to the second embodiment of the present invention. Components same as those shown in FIG. 1 are denoted by the same reference numerals and signs and redundant explanation is omitted.

The capacitor abnormality detecting apparatus according to the second embodiment includes, as shown in FIG. 2, a voltage detecting circuit 25a as a first voltage detecting circuit that detects a differential voltage between a bus voltage of the DC bus 7P in the DC power supply circuit 10a and a bus voltage of the DC bus 8P in the DC power supply circuit 10b, a voltage detecting circuit 25b as a second voltage detecting circuit that detects a voltage (a potential difference) between a terminal voltage of one capacitor (in FIG. 2, the capacitor 4c is shown as an example) arbitrarily selected out of the capacitors 4a to 4c and a terminal voltage of one capacitor (in FIG. 2, the capacitor 5c is shown as an example) arbitrarily selected out of the capacitors 5a to 5c, a constant multiplication circuit 26 that multiplies an output voltage of the voltage detecting circuit 25a with a constant (in FIG. 2, 1/3 is shown as an example), and a comparing and determining circuit 28 that outputs a predetermined comparison and determination result based on a differential voltage between an output voltage of the constant multiplication circuit 26 and an output voltage of the voltage detecting circuit 25b. Matters taken into account when capacitance values of the capacitors are not equal and matters taken into account concerning detection positions of capacitor voltages are the same as those in the first embodiment.

The operation of the capacitor abnormality detecting apparatus according to the second embodiment is explained with reference to FIG. 2.

<Operation performed when there is no abnormality in the capacitor groups>

First, when the capacitors 4a to 4c normally operate, terminal voltages of the capacitors 4a to 4c are balanced. Therefore, one input voltage to the voltage detecting circuit 25b is "$V_{S1}/3$". Similarly, when the capacitors 5a to 5c normally operate, the other input voltage to the voltage detecting circuit 25b is "$V_{S2}/3$". Therefore, the output voltage of the voltage detecting circuit 25b is "$(V_{S1}-V_{S2})/3$", which is a differential voltage between both the input voltages.

On the other hand, because a voltage of the DC bus 7P and a voltage of the DC bus 8P are input to the voltage detecting circuit 25a, the output voltage of the voltage detecting circuit 25a is "$V_{S1}-V_{S2}$". Therefore, an output of the constant multiplication circuit 26 is "$(V_{S1}-V_{S2})/3$".

Therefore, even if slight fluctuation occurs in a terminal voltage of the capacitor 4c or the capacitor 5c because of, for example, output voltage fluctuation in the DC power supply 1 or the DC power supply 2, there is no significant difference between the output voltage of the constant multiplication circuit 26 and the output voltage of the voltage detecting circuit 25b, which are input voltages to the comparing and determining circuit 28. A comparison and determination result, which is an output of the comparing and determining circuit 28, is "normal".

<Operation performed when there is abnormality in one of the capacitor groups>

As in the first embodiment, an operation performed when only the capacitor 4a is short-circuited and fails is explained. When the capacitor 4a is short-circuited and fails, the output voltage $V_{S1}$ of the DC power supply 1 is applied to both ends of the capacitor 4b and the capacitor 4c. Therefore, an output voltage of the capacitor 4c rises to "$V_{S1}/2$".

Therefore, an output voltage of the voltage detecting circuit 25b is "$(V_{S1}/2)-(V_{S2}/3)$". As in the first embodiment, a potential difference indicated by the above Formula (1) occurs between the output voltage "$(V_{S1}-V_{S2})/3$" of the constant multiplication circuit 26 and the output voltage "$(V_{S1}/2)-(V_{S2}/3)$" of the voltage detecting circuit 25b, which are input voltages to the comparing and determining circuit 28. The comparing and determining circuit 28 can detect this potential difference and detect "capacitor abnormality in the DC power supply circuit 10a" as a comparison and determination result.

Other operations including an operation for detecting "capacitor abnormality in the DC power supply circuit 10b" are the same as those in the first embodiment and redundant explanation is omitted.

In FIG. 2, the embodiment in which the two DC power supplies to which the DC buses on the negative side are connected in common are configured is shown. However, in the case of a power supply system in which an even number of DC power supplies are configured, it is sufficient to divide the DC power supplies into groups each including two DC power supplies, set one DC power supply belonging to each of the groups as the DC power supply 1 and set the other DC power supply as the DC power supply 2, and apply the circuit configuration explained in this embodiment.

As explained above, with the capacitor abnormality detecting apparatus according to the second embodiment, when 2n (n is a natural number) DC power supplies to which DC buses on a negative side are connected in common are configured, the first voltage detecting circuit divides the 2n DC power supplies into n groups grouped in a unit of two DC power supplies and detects a voltage between a DC bus on a positive side in one DC power supply of one and the other DC power supplies belonging to each of the n groups and a DC bus on the positive side in the other DC power supply, the second voltage detecting circuit detects a differential voltage between a terminal voltage of any one capacitor belonging to a first capacitor group connected between DC buses in one DC power supply and a terminal voltage of any one capacitor belonging to a second capacitor group connected between DC buses in the other DC power supply, and the comparing and determining circuit determines abnormality of a capacitor belonging to the first capacitor group or the second capacitor group based on output voltages of the first to third voltage detecting circuits. Therefore, it is possible to further reduce circuit main components necessary for the capacitor abnormality detecting apparatus.

Third Embodiment.

In the capacitor abnormality detecting apparatus according to the second embodiment, as the configuration for detecting abnormality of the capacitor groups respectively connected to the two DC power supplies, the configuration realized by the two voltage detecting circuits and the one comparing and determining circuit is disclosed. In a capacitor abnormality detecting apparatus according to a third embodiment, as a configuration for detecting abnormality of capacitor groups respectively connected to three DC power supplies, a configuration realized by four voltage detecting circuits and two comparing and determining circuits is disclosed. FIG. 3 is a circuit diagram of the configuration of the capacitor abnormality detecting apparatus according to the third embodiment of the present invention. Components same as those shown in FIGS. 1 and 2 are denoted by the same reference numerals and signs and redundant explanation is omitted.

As it can be understood from comparison of a connection configuration shown in FIG. 2 and a connection configuration shown in FIG. 3, the capacitor abnormality detecting apparatus according to the third embodiment includes a DC power supply 3, capacitors 6a to 6c, and resistors 13a to 13c in addition to the components in the second embodiment. The capacitor abnormality detecting apparatus includes a DC power supply circuit 10c in which a DC bus 9N on a negative side is connected in common to the other DC buses 7N and 8N on the negative side, a voltage detecting circuit 32 as a third voltage detecting circuit that detects a differential voltage between a bus voltage of a DC bus 8P in the DC power supply circuit 10b (which can be a bus voltage of the DC bus 7P in the DC power supply circuit 10a) and a bus voltage of a DC bus 9P on a positive side in the DC power supply circuit 10c, a voltage detecting circuit 34 that detects a voltage (a potential difference) between a terminal voltage of the capacitor 5c (which can be a terminal voltage of the capacitor 4c) selected as an input signal to the voltage detecting circuit 25b and a terminal voltage of one capacitor (in FIG. 3, the capacitor 6c is shown as an example) arbitrarily selected out of the capacitors 6a to 6c, a constant multiplication circuit 36 that multiplies an output voltage of the voltage detecting circuit 32 with a constant (in FIG. 3, 1/3 is shown as an example), and a comparing and determining circuit 38 as a second comparing and determining circuit that outputs a predetermined comparison and determination result based on a differential voltage between an output voltage of the constant multiplication circuit 36 and an output voltage of the voltage detecting circuit 34. Matters taken into account when capacitance values of the capacitors are not equal and matters taken into account concerning detection positions of capacitor voltages are the same as those in the first and second embodiments.

The operation of the capacitor abnormality detecting apparatus according to the third embodiment is explained with reference to FIG. 3.

<Operation performed when there is no abnormality in the capacitor groups>

First, when the capacitors 4a to 4c normally operate, terminal voltages of the capacitors 4a to 4c are balanced. Therefore, one input voltage to the voltage detecting circuit 25b is "$V_{S1}/3$". When the capacitors 5a to 5c normally operate, the other input voltage to the voltage detecting circuit 25b is "$V_{S2}/3$". Therefore, the output voltage of the voltage detecting circuit 25b is "$(V_{S1}-V_{s2})/3$", which is a differential voltage between both the input voltages. The same explanation can be applied to the voltage detecting circuit 34. The output voltage of the voltage detecting circuit 34 is "$(V_{S2}-V_{S3})/3$".

On the other hand, because a voltage of the DC bus 7P and a voltage of the DC bus 8P are input to the voltage detecting circuit 25a, the output voltage of the voltage detecting circuit 25a is "$V_{S1}-V_{S2}$". Therefore, an output of the constant multiplication circuit 26 is "$(V_{S1}-V_{S2})/3$". The same explanation can be applied to the voltage detecting circuit 32. The output voltage of the voltage detecting circuit 32 is "$V_{S2}-V_{S3}$" and an output of the constant multiplication circuit 36 is "$(V_{S2}-V_{S3})/3$".

Therefore, even if slight fluctuation occurs in a terminal voltage of the capacitor 4c or the capacitor 5c because of, for example, output voltage fluctuation in the DC power supply 1 or the DC power supply 2, there is no significant difference between the output voltage of the constant multiplication circuit 26 and the output voltage of the voltage detecting circuit 25b, which are input voltages to the comparing and determining circuit 28. A first comparison and determination result, which is an output of the comparing and determining circuit 28, is "normal". Similarly, even if slight fluctuation occurs in a terminal voltage of the capacitor 5c or the capacitor 6c because of, for example, output voltage fluctuation in the DC power supply 2 or the DC power supply 3, there is no significant difference between the output voltage of the constant multiplication circuit 36 and the output voltage of the voltage detecting circuit 34, which are input voltages to the comparing and determining circuit 38. A second comparison and determination result, which is an output of the comparing and determining circuit 38, is "normal".

<Operation performed when there is abnormality in one of the capacitor groups>

As in the first and second embodiments, an operation performed when only the capacitor 4a is short-circuited and fails is explained. When the capacitor 4a is short-circuited and fails, the output voltage $V_{S1}$ of the DC power supply 1 is applied to both ends of the capacitor 4b and the capacitor 4c. Therefore, an output voltage of the capacitor 4c rises to "$V_{S1}/2$".

Therefore, an output voltage of the voltage detecting circuit 25b is "$(V_{S1}/2)-(V_{S2}/3)$". As in the first and second embodiments, a potential difference indicated by the above Formula (1) occurs between the output voltage "$(V_{S1}-V_{S2})/3$" of the constant multiplication circuit 26 and the output voltage "$(V_{S1}/2)-(V_{S2}/3)$" of the voltage detecting circuit 25b, which are input voltages to the comparing and determining circuit 28.

On the other hand, output voltages of the normal capacitors 5c and 6c are input to the voltage detecting circuit 34. Therefore, the comparing and determining circuit 38 detects a balanced potential difference between terminal voltages of the capacitors 5c and 6c and outputs "normal" as the second comparison and determination result.

Therefore, because the first comparison and determination result is "negative" and the second comparison and determination result is "normal", the capacitor abnormality detecting apparatus detects "capacitor abnormality of the DC power supply circuit 10a".

In the case of the configuration shown in FIG. 3, when only the first comparison and determination result is "capacitor abnormal", the capacitor abnormality detecting apparatus can detect "capacitor abnormality of the DC power supply circuit 10a". When only the second comparison and determination result is "capacitor abnormal", the capacitor abnormality detecting apparatus can detect "capacitor abnormality of the DC power supply circuit 10c". When both the first and second comparison and determination results are "capacitor abnormal", the capacitor abnormality detecting apparatus can detect "capacitor abnormality of the DC power supply circuit 10b".

Other operations including detection of capacitor abnormality other than the short circuit and failure are the same as those in the first and second embodiments and redundant explanation is omitted.

In FIG. 3, the embodiment in which the three DC power supplies to which the DC buses on the negative side are connected in common are configured is explained as the configuration in which the one DC power supply, the two voltage detecting circuits, and the one comparing and determining circuit are added to the configuration of the second embodiment including the two DC power supplies to which the DC buses on the negative side are connected in common shown as shown in FIG. 2. If this configuration is expanded, the configuration can be applied to a power supply system in which three or more and odd number of DC power supplies are configured. Specifically, when (2n+1) (n is a natural number) DC power supplies to which the DC buses on the negative side are connected in common are configured, it is sufficient to divide the (2n+1) DC power supplies into n groups, which are formed by dividing 2n DC power supplies of the (2n+1) DC power supplies into groups each including two DC power supplies, and the remaining one DC power supply, apply the circuit configuration explained in the second embodiment to the n groups each including two DC power supplies, and apply the circuit configuration explained in the third embodiment to the remaining one DC power supply.

Lastly, the numbers of the voltage detecting circuits and the comparing and determining circuits in the circuits according to the first to third embodiments and the numbers of the voltage detecting circuits and the comparing and determining circuits in the circuit of Patent Literature 1 mentioned in the background are compared. A logic circuit, an inverted logic gate, and a zener diode in Patent Literature 1 and the adding and subtracting circuit and the constant multiplication circuit in the first embodiment are excluded from comparison targets because circuit sizes thereof are small compared with the voltage detecting circuits and the comparing and determining circuits.

First, in the circuit of Patent Literature 1, two voltage detecting circuits and one comparing and determining circuit are necessary with respect to one capacitor group connected in series to one DC power supply. On the other hand, in the circuit of the first embodiment, as shown in FIG. 1, because there are the two DC power supplies and the three voltage detecting circuits, the circuit can be configured by 1.5 pieces of voltage detecting circuits and one comparing and determining circuit with respect to one capacitor group connected in series to one DC power supply. Therefore, in the capacitor abnormality detecting apparatus according to the first embodiment, the number of components is reduced compared with the circuit in the past.

In the circuit of the second embodiment, as shown in FIG. 2, the two voltage detecting circuits and the one comparing and determining circuit are necessary with respect to the two DC power supplies. In the circuit of the third embodiment, as shown in FIG. 3, the four voltage detecting circuits and the two comparing and determination circuits are necessary with respect to the three DC power supplies. Therefore, in the capacitor abnormality detecting apparatuses according to the second and third embodiments, the number of components with respect to the number of DC power supplies is reduced compared with the circuit in the past and the circuit of the first embodiment.

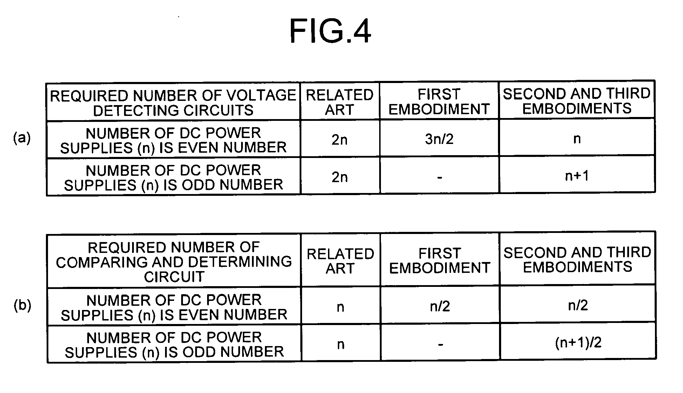

FIG. 4 is a table in which required numbers of voltage detecting circuits and comparing and determining circuits are shown in comparison with each other. (a) of the figure indicates a required number of voltage detecting circuits and (b) indicates a required number of comparing and determining circuits. As shown in FIG. 4, as the number of DC power supplies (n) increases, an effect of reducing the required number of voltage detecting circuits and the required number of comparing and determining circuits increases. Therefore, the capacitor abnormality detecting apparatus according to this embodiment is suitable for a power supply system in which a DC power supply is provided for each solar cell module such as a solar cell power generation system.

As explained above, with the capacitor abnormality detecting apparatus according to the third embodiment, when (2n+1) (n is a natural number) DC power supplies to which DC buses on a negative side are connected in common are configured, the first voltage detecting circuit divides the (2n+1) DC power supplies into n groups, which are formed by grouping 2n DC power supplies of the (2n+1) DC power supplies into groups in a unit of two DC power supplies, and the remaining one DC power supply, detects a voltage between a DC bus on a positive side in one DC power supply of one and the other DC power supplies belonging to each of the n groups and a DC bus on the positive side in the other DC power supply, the second voltage detecting circuit detects a differential voltage between a terminal voltage of any one capacitor belonging to a first capacitor group connected between DC buses in one DC power supply and a terminal voltage of any one capacitor belonging to a second capacitor group connected between DC buses in the other DC power supply, the first comparing and determining circuit determines abnormality of a capacitor belonging to the first capacitor group or the second capacitor group based on output voltages of the first and second voltage detecting circuits, the third voltage detecting circuit detects a voltage between a DC bus on the positive side in a DC power supply arbitrarily selected out of the DC power supplies belonging to the n groups and a DC bus on the positive side in the remaining one DC power supply, the fourth voltage detecting circuit detects a differential voltage between a terminal voltage of any one capacitor belonging to the first or second capacitor group connected between the DC buses in the selected DC power supply and a terminal voltage of any one capacitor belonging to a third capacitor group connected between the DC buses in the remaining one DC power supply, and the second comparing and determining circuit determines abnormality of a capacitor belonging to the first to third capacitor groups based on output voltages of the third and fourth voltage detecting circuits. Therefore, it is possible to further reduce circuit main components necessary for the capacitor abnormality detecting apparatus.

In the first to third embodiments, the configuration including the resistors that, in the same manner as the capacitor groups connected between the DC buses, are connected between the DC buses and connected in parallel to the capacitors included in the capacitor groups and divide a voltage between the DC buses is explained as an example. However, these resistors can be omitted.

However, when the resistors are omitted, because of, for example, aged deterioration of the capacitors, it is likely that capacitor capacitances fluctuate and irregularity occurs between the capacitor capacitances and input voltages to the voltage detecting circuits fluctuate. Therefore, in determination processing by the comparing and determining circuits in the case of the configuration in which the resistors are omitted, determination processing that takes into account the fluctuation in the capacitor capacitances due to the aged deterioration of the capacitors is desired.

Industrial Applicability

As explained above, the capacitor abnormality detecting apparatus according to the present invention is useful as an invention for enabling a further reduction in circuit main components.

Reference Signs List

    1 to 3 DC POWER SUPPLIES
    4a to 4c, 5a to 5c, 6a to 6c CAPACITORS
    7P, 7N, 8P, 8N, 9P, 9N DC BUSES
    10a to 10c DC POWER SUPPLY CIRCUITS
    11a to 11c, 12a to 12c, 13a to 13c RESISTORS
    15a to 15c, 25a, 25b, 32, 34 VOLTAGE DETECTING CIRCUITS
    16a, 16b, 26, 36 CONSTANT MULTIPLICATION CIRCUITS
    17 ADDING AND SUBTRACTING CIRCUIT
    18, 28, 38 COMPARING AND DETERMINING CIRCUITS

**Claims**

1. A capacitor abnormality detecting apparatus that detects abnormality of a capacitor group including a plurality of capacitors connected in series between DC buses of a DC power supply, the DC power supply including first and second DC power supplies to which DC buses on a negative side are connected in common, the capacitor abnormality detecting apparatus comprising:

    a first voltage detecting circuit that detects a voltage between first DC buses in the first DC power supply;
    a second voltage detecting circuit that detects a voltage between second DC buses in the second DC power supply;
    a third voltage detecting circuit that detects a differential voltage between a terminal voltage of any one capacitor belonging to a first capacitor group connected between the first DC buses and a terminal voltage of any one capacitor belonging to a second capacitor group connected between the second DC buses; and
    a comparing and determining circuit that determines abnormality of capacitors belonging to the first capacitor group or the second capacitor group based on output voltages of the first to third voltage detecting circuits.

2. A capacitor abnormality detecting apparatus that detects abnormality of a capacitor group including a plurality of capacitors connected in series between DC buses of a DC power supply, the DC power supply including 2n (n is a natural number) DC power supplies to which DC buses on a negative side are connected in common, the capacitor abnormality detecting apparatus comprising:

a first voltage detecting circuit that divides the 2n DC power supplies into n groups grouped in a unit of two DC power supplies and detects a voltage between a DC bus on a positive side in one DC power supply of one and the other DC power supplies belonging to each of the n groups and a DC bus on the positive side in the other DC power supply;

a second voltage detecting circuit that detects a differential voltage between a terminal voltage of any one capacitor belonging to a first capacitor group connected between DC buses in the one DC power supply and a terminal voltage of any one capacitor belonging to a second capacitor group connected between DC buses in the other DC power supply; and

a comparing and determining circuit that determines abnormality of capacitors belonging to the first capacitor group or the second capacitor group based on output voltages of the first and second voltage detecting circuits, the first voltage detecting circuit, the second voltage detecting circuit, and the comparing and determining circuit being provided for each of the divided groups.

3. A capacitor abnormality detecting apparatus that detects abnormality of a capacitor group including a plurality of capacitors connected in series between DC buses of a DC power supply, the DC power supply including (2n+1) (n is a natural number) DC power supplies to which DC buses on a negative side are connected in common, the capacitor abnormality detecting apparatus comprising:

a first voltage detecting circuit that divides the (2n+1) DC power supplies into n groups, which are formed by grouping 2n DC power supplies of the (2n+1) DC power supplies in a unit of two DC power supplies, and remaining one DC power supply, detects a voltage between a DC bus on a positive side in one DC power supply of one and the other DC power supplies belonging to each of the n groups and a DC bus on the positive side in the other DC power supply;

a second voltage detecting circuit that detects a differential voltage between a terminal voltage of any one capacitor belonging to a first capacitor group connected between DC buses in the one DC power supply and a terminal voltage of any one capacitor belonging to a second capacitor group connected between DC buses in the other DC power supply; and

a first comparing and determining circuit that determines abnormality of capacitors belonging to the first capacitor group or the second capacitor group based on output voltages of the first and second voltage detecting circuits, the first voltage detecting circuit, the second voltage detecting circuit, and the first comparing and determining circuit being provided for each of the groups;

a third voltage detecting circuit that detects a voltage between a DC bus on the positive side in a DC power supply arbitrarily selected out of DC power supplies belonging to the n groups and a DC bus on the positive side in the remaining one DC power supply;

a fourth voltage detecting circuit that detects a differential voltage between a terminal voltage of any one capacitor belonging to the first or second capacitor group connected between DC buses in the selected DC power supply and a terminal voltage of any one capacitor belonging to a third capacitor group connected to DC buses in the remaining one DC power supply; and

a second comparing and determining circuit that determines abnormality of capacitors belonging to the first to third capacitor groups based on output voltages of the third and fourth voltage detecting circuits.

4. The capacitor abnormality detecting apparatus according to any one of claims 1 to 3, further comprising resistors that are connected in parallel to the capacitors included in the capacitor groups and connected in series to be connected between the DC buses and divide a voltage between the DC buses.

# FIG.1

# FIG.2

# FIG.3

# FIG.4

(a)

| REQUIRED NUMBER OF VOLTAGE DETECTING CIRCUITS | RELATED ART | FIRST EMBODIMENT | SECOND AND THIRD EMBODIMENTS |
|---|---|---|---|
| NUMBER OF DC POWER SUPPLIES (n) IS EVEN NUMBER | 2n | 3n/2 | n |
| NUMBER OF DC POWER SUPPLIES (n) IS ODD NUMBER | 2n | - | n+1 |

(b)

| REQUIRED NUMBER OF COMPARING AND DETERMINING CIRCUIT | RELATED ART | FIRST EMBODIMENT | SECOND AND THIRD EMBODIMENTS |
|---|---|---|---|
| NUMBER OF DC POWER SUPPLIES (n) IS EVEN NUMBER | n | n/2 | n/2 |
| NUMBER OF DC POWER SUPPLIES (n) IS ODD NUMBER | n | - | (n+1)/2 |

**INTERNATIONAL SEARCH REPORT**

| International application No. |
|---|
| PCT/JP2009/062758 |

A. CLASSIFICATION OF SUBJECT MATTER
G01R31/00(2006.01)i, G01R31/02(2006.01)i, H01G13/00(2006.01)i

According to International Patent Classification (IPC) or to both national classification and IPC

B. FIELDS SEARCHED

Minimum documentation searched (classification system followed by classification symbols)
G01R31/00-04, H01G13/00

Documentation searched other than minimum documentation to the extent that such documents are included in the fields searched
| Jitsuyo Shinan Koho | 1922–1996 | Jitsuyo Shinan Toroku Koho | 1996–2009 |
| Kokai Jitsuyo Shinan Koho | 1971–2009 | Toroku Jitsuyo Shinan Koho | 1994–2009 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 4-120475 A (Toshiba Corp.), 21 April 1992 (21.04.1992), entire text; all drawings (Family: none) | 1-4 |
| A | JP 2000-184611 A (Hitachi, Ltd.), 30 June 2000 (30.06.2000), entire text; all drawings & US 6157165 A & EP 992811 A2 & TW 472426 B & KR 10-2000-0028851 A | 1-4 |

☐ Further documents are listed in the continuation of Box C.   ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 07 September, 2009 (07.09.09) | 20 October, 2009 (20.10.09) |

| Name and mailing address of the ISA/ | Authorized officer |
|---|---|
| Japanese Patent Office | |
| Facsimile No. | Telephone No. |

Form PCT/ISA/210 (second sheet) (April 2007)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H4120475 B